# EUROPÄISCHE PATENTSCHRIFT

(11) **EP 1 783 521 B1**
(45) Veröffentlichungstag und Bekanntmachung des Hinweises auf die Patenterteilung: **28.05.2008**
(21) Anmeldenummer: 05023843.5
(22) Anmeldetag: 02.11.2005
(51) Int. Cl.: G02B 6/38, H01R 24/00, H01R 31/06

(54) **Steckverbinder und Steckkupplung in Form eines RJ45-Anschlusssystems**
Connector and RJ-45 connexion system.
Connecteur et systeme de connexion RJ-45

(43) Veröffentlichungstag der Anmeldung: 09.05.2007
(73) Patentinhaber: TKM Telekommunikation und Elektronik GmbH, 41238 Mönchengladbach (DE)
(72) Erfinder: Gerlach, Bernd, 64297 Darmstadt (DE); Feltgen, Reinhard, 52477 Alsdorf - Höngen (DE); Oudshoom, Frans, 31592 Stolzenau (DE)
(74) Vertreter: Meyer, Ludgerus

(56) Entgegenhaltungen:
- EP-A- 1 211 537
- EP-A- 1 258 759
- WO-A-03/016972
- DE-U1- 20 202 835
- US-A1- 2005 118 880
- US-B1- 6 364 535

## Beschreibung

Die Erfindung betrifft einen Steckverbinder in Form eines RJ45-Anschlusssystems für elektrische und Lichtwellenleiterkabel, insbesondere Hybrid-Datenkabel, nach dem Oberbegriff des Anspruchs 1 sowie eine Steckkupplung in Form eines RJ45-Anschlusssystems nach dem Oberbegriff des Anspruchs 9.

Steckverbindungen für die heutige Datenübertragungstechnik werden üblicherweise entweder als elektrische Steckverbindungen mit RJ45-Anschlusselementen ausgebildet oder als Lichtwellenleiter, die teilweise ebenfalls RJ45-Anschlussenden aufweisen.

In gemischten Netzen kommen sowohl elektrische Leitungen als auch Lichtwellenleiter zum Einsatz, so dass ein großer Bedarf an mit derartigen Anschlüssen versehenen Kabeln besteht.

Es sind auch Hybridkabel bekannt, die in einem gemeinsamen Kabelmantel sowohl elektrische Leiter als auch Lichtwellenleiter aufnehmen. Üblicherweise werden die Leiterenden an getrennte Steckverbinder geführt.

Aus der DE 203 17 751 ist ein Stecksystem zur Herstellung einer Lichtwellenleitersteckverbindung für ein Lichtwellenleiterkabel bekannt geworden, bei dem ein RJ45-Anschlusssystem verwendet wird. Dort ist eine Kupplungsbuchse dargestellt, in die RJ45-Stecker eingesteckt werden können, durch die Lichtwellenleiter miteinander gekoppelt werden können. Der Gehäusekörper weist Bohrungen zur Aufnahme der Enden der Lichtwellenleiter auf, die, in einer Keramikhülse geführt, stirnseitig gegeneinander gerichtet werden können.

Aus der EP 1 199 587 ist ein Anschlusssystem für ein Hybridkabel mit einem Lichtwellenleiter und parallel dazu laufenden elektrischen Leitern bekannt, die in einem gemeinsamen Stecker kontaktierbar sind. Dabei weist die Unterseite des Steckers elektrische Kontakte auf, die Federkontakte am vorderen Ende einer Buchse kontaktieren können, welche auf einer Platine befestigt ist. Die Befestigung der Leiter an dem Stecker ist allerdings aufwändig realisiert. EP 1 199 587 offenbart einen Steckverbinder gemäß dem Oberbegriff des Anspruchs 1 und eine Steckkupplung gemäß dem Oberbegriff des Anspruchs 9.

Aus der DE 202 02 835 U1 ist ferner eine optische Verbindungseinrichtung bekannt, bei der eine Steckkupplung zur Aufnahme zweier Steckverbinder, die jeweils Lichtwellenleiter und elektrische Kontakte enthalten, vorgesehen ist, wobei die Steckkupplung als Führungsblock, bestehend aus zwei gegeneinander gerichteten Halbblöcken, zur Aufnahme und Ausrichtung der zu koppelnden Lichtwellenleiter ausgebildet ist. Dabei dient eine aufgesetzte Platine der Kontaktierung der elektrischen Leiter.

Der Erfindung liegt die Aufgabe zugrunde, eine Steckverbindung in Form eines RJ45-Anschlusssystems anzugeben, die für elektrische und Lichtwellenleiterkabel, insbesondere für Hybridkabel, verwendbar ist, eine hohe Störstrahlfestigkeit ermöglicht und auch für Kabel mit mehreren Lichtwellenleitern geeignet ist.

Diese Aufgabe wird durch die in dem Anspruch 1 angegebene Erfindung gelöst. Vorteilhafte Weiterbildungen der Erfindung sind in den Unteransprüchen angegeben.

Die Erfindung gemäß Anspruch 1 betrifft einen Steckverbinder in Form eines RJ45-Anschlusssystems für ein Datenkabel mit wenigstens einem Lichtwellenleiter und dazu parallel geführten elektrischen Leitern, mit einer Halterung für ein Ende des Lichtwellenleiter, mit elektrischen Kontakten sowie einem Gehäuse zur Aufnahme der Halterung und der Kontakte.

Mittels solcher Steckverbinder können Kombinationen von elektrischen und Lichtwellenleiterkabeln, insbesondere Hybrid-Datenkabel, an eine Steckkupplung oder eine geräteseitige Buchse angeschlossen werden, wobei durch das Einstecken in die entsprechende Buchse sowohl ein elektrischer als auch ein Lichtwellenleiterkontakt herstellbar ist.

Gemäß der Erfindung weist das Gehäuse des Steckverbinders einen die Halterung bildenden quaderförmigen Verbindungsblock auf, der wenigstens zwei Durchlässe zur Führung von wenigstens zwei Lichtwellenleitern aufweist. Eine Platine enthält Anschlusselemente zum Anschluss der elektrischen Leiter des Datenkabels. Diese ist mit einer Seite des Verbindungsblocks verbindbar und enthält parallel angeordnete Kontaktbahnen, die über Durchbrüche einer den Verbindungsblock und die Platine umgebenden Formhülse zur Kontaktierung der Anschlussdrähte von anzuschließenden elektrischen Verbindern zugänglich sind.

Ein solcher Steckverbinder ist daher aus einzelnen Elementen zusammengesetzt, die einfach herstellbar und zusammensetzbar sind, aber in ihrer Gesamtausbildung einen hochfesten, präzisen und professionellen Ansprüche erfüllenden Steckverbinder realisiert. Die Durchlässe zur Führung der Lichtwellenleiter erlauben eine präzise Ausrichtung zur möglichst verlustfreien Übertragung von Lichtwellenenergie. Die elektrischen Kontakte sind gleichzeitig geschützt angeordnet und ermöglichen eine präzise Führung von Kontaktdrähten.

Vorzugsweise weist die Platine Schneidklemmen zum Anschluss der elektrischen Leiter des Kabels auf. Die Verbindung und Sicherung der elektrischen Leiter an den Schneidklemmen erfolgt vorzugsweise durch Aufbringen eines Druckblocks quer über die Schneidklemmen, so dass ein schnelles und sicheres Auflegen gewährleistet ist.

Vorzugsweise enthält die verwendete Formhülse Ausnehmungen zur mechanischen Verrastung mit Federnasen des Verbindungsblocks. Die Formhülse dient einerseits dem Schutz der elektrischen Anschlüsse, stellt andererseits Führungsdurchbrüche für die Anschlussdrähte einer anzuschließenden Buchse sowie eine Verriegelungsvorrichtung bereit, um den Steckverbinder auf üblichem Wege in der Buchse zu verrasten.

Zur weiteren Verbesserung der Lichtwellenleiterführung können die im Verbindungsblock vorgesehenen Durchlässe Kunststoff-, Metall- oder Keramikhülsen aufweisen.

Das Gehäuse des Steckverbinders ist vorzugsweise mehrteilig ausgebildet, wobei die einzelnen Gehäuseteile miteinander verrastet werden können. Mittels einer Kabelklemmhülse am hinteren Ende des Gehäuses lässt sich das kombinierte oder Hybridkabel fest mit dem Steckverbinder fixieren.

In einer weitergehenden Ausführungsform kann vorgesehen sein, dass die Platine Bestandteil des Führungsblocks ist oder alternativ fest mit dem Führungsblock verrastet, verklebt oder verschweißt ist.

Die Erfindung betrifft in einer weiterführenden Ausbildungsform auch eine Steckkupplung in Form eines RJ45-Anschlusssystems zur Aufnahme zweier Steckverbinder zur Verbindung zweier Datenkabel, insbesondere Hybridkabel, mit je wenigstens einem Lichtwellenleiter und dazu parallel geführten elektrischen Leitern, mit Halterungen für die Enden der Lichtwellenleiter und mit elektrischen Kontakten sowie einem Gehäuse, wobei ein quaderfömiger Führungsblock mit zwei fluchtenden Axialbohrungen zur Aufnahme und Ausrichtung der zu koppelnden Lichtwellenleitern vorgesehen ist. Solche Steckkupplungen dienen dazu, zwei mit endseitigen Steckverbindern versehene Kabel miteinander zu koppeln, um z. B. die Kabellänge zu vergrößern.

Vorzugsweise weist der quaderförmige Führungsblock zwei stirnseitig gegeneinander gesetzte Halteblöcke auf. An der Außenseite des Führungsblocks ist eine Platine mit zwei darauf jeweils endseitig angeordneten Federdrahtsätzen zur elektrischen Kopplung der zu verbindenden Steckverbinder vorgesehen. Der Führungsblock und die Platine sind miteinander ausgerichtet in einem zweiteiligen Kupplungsgehäuse aufgenommen, wobei die Platine den Führungsblock beidseitig überragt.

Eine solche Steckkupplung bildet insbesondere das Gegenstück eines Steckverbinders der in Anspruch 1 angegebenen Art.

Vorzugsweise enthält der Führungsblock in seinen Axialbohrungen verankerte Kunststoff-, Metall oder Keramikhülsen, um die Präzision der Führung beidseitig in die Steckkupplung eingesteckter Lichtwellenleiter zu erhöhen.

Die in der Steckkupplung verwendeten Halbblöcke sind vorzugsweise mittels in Sacklöcher des einen Halbblocks eingreifende Stecknasen des anderen Halbblocks zueinander ausgerichtet und miteinander fixierbar.

Die verwendete Platine enthält beidseitig auf der Platine aufgelötete Federdrahtsätze zur Kontaktierung der Leiterbahnen anzuschließender Steckverbinder. Die Federdrahtsätze der beiden Enden der Platine sind auf der Platine geeignet miteinander verschaltet. Anstelle von Leiterbahnen auf der Platine können die Federdrahtsätze auch über Drahtverbindungen miteinander verbunden sein.

Das erfindungsgemäße Steckverbindersystem, gebildet aus einem Steckverbinder gemäß Anspruch 1 und einer Steckkupplung gemäß Anspruch 9 ist in gemischten Netzen mit großem Vorteil einsetzbar, da insbesondere Hybridkabel durch einen einzigen Steckvorgang sowohl eine elektrische als auch eine Lichtwellenleiterverbindung ermöglichen. Anders als konventionelle Steckverbinder, die entweder nur als Lichtwellenleiterverbinder oder als konventionelle RJ45-Kupferkabelstecker mit aufgesetzten Aufnahmevorrichtungen für Lichtwellenleiterfasern ausgebildet sind, ist der Steckverbinder gemäß der Erfindung kompatibel zu anderen Kupfersystemen, der nur geringe räumliche Ausdehnung hat, eine sichere Verbindung ermöglicht und hohen Anforderungen gerecht wird. Die Steckverbindungen können vor Ort hergestellt werden, da keine besonderen Werkzeuge erforderlich sind. Aufgrund ihrer modularen Ausbildung kann die Steckverbindung auch vor Ort repariert oder ersetzt werden.

Die Erfindung wird nachstehend anhand zweier Ausführungsbeispiele näher erläutert. Es zeigen:
- Fig. 1: einen Steckverbinder der erfindungsgemäßen Art in perspektivischer Ansicht,
- Fig. 2: einen Steckverbinder nach Fig. 1 mit entferntem Gehäuse,
- Fig. 3: einen Steckverbinder gemäß Fig. 2 mit entferntem Anschlusskabel,
- Fig. 4: einen Steckverbinder gemäß Fig. 3 ohne Formhülse,
- Fig. 5: eine Platine zum Einsatz in einen Steckverbinder gemäß Fig. 1,
- Fig. 6: eine Aufsicht auf eine Platine mit dargestellten Leiterbahnen,
- Fig. 7: eine Aufsicht auf eine Platine,
- Fig. 8: eine Steckkupplung,
- Fig. 9: eine Steckkupplung mit entfernter erster Gehäusehälfte,
- Fig. 10: eine Steckkupplung ohne Gehäuse,
- Fig. 11: die Anordnung eines Halbblocks in Bezug auf eine Platine,
- Fig. 12: eine Platine mit einer Darstellung von Führungshülsen,
- Fig. 13: eine Platine,
- Fig. 14: eine erste Aufsicht auf eine Platine, und
- Fig. 15: eine weitere Aufsicht auf eine Platine.

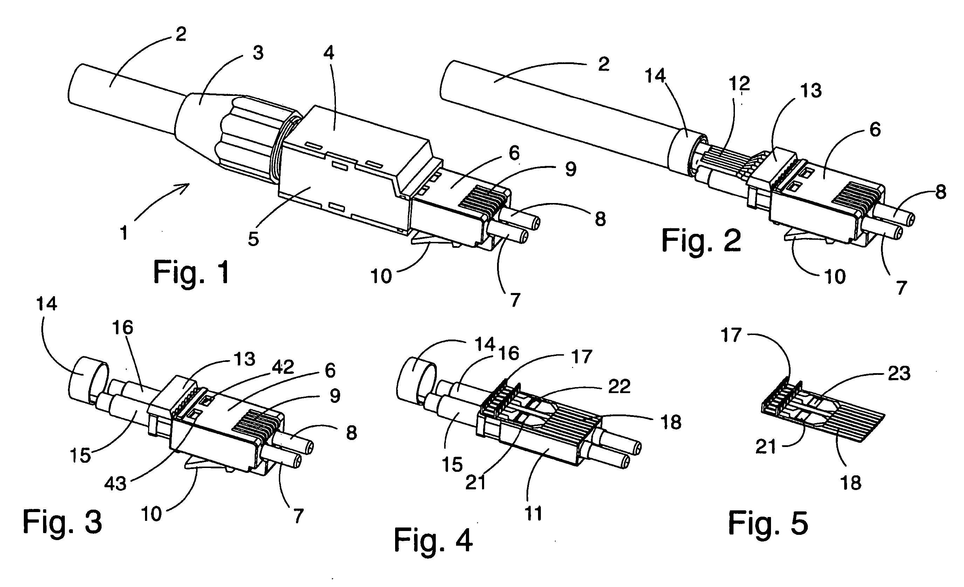

Der in Fig. 1 dargestellte Steckverbinder 1 weist ein Gehäuse auf, das aus zwei dünnwandigen Gehäuseteilen 4 und 5 gebildet ist, die über Rastnasen miteinander gekoppelt sind. Am rückwärtigen Ende der Gehäuseteile ist eine Verschraubung 3 angeordnet, die der Klemmung eines anzuschließenden Hybridkabels 2 dient. Aus dem im Wesentlichen quaderförmigen Gehäuse ragt an seiner Vorderseite eine Formhülse 6 heraus, die entsprechend einem RJ45-Stecker ausgestattet ist. Darin sind in Längsrichtung parallel verlaufende Durchbrüche 9 vorgesehen, die eng nebeneinanderliegende Durchbrüche zum Anschluss von Federdrahtsätzen einer Buchse oder einer Kupplung bilden. An der Stirnseite treten zwei Lichtwellenleiter 7 und 8 aus der Formhülse 6 heraus. An der Unterseite der Formhülse ist eine übliche RJ45-Verriegelungsvorrichtung 10 ausgebildet.

Fig. 2 zeigt eine Ansicht von Fig. 1, bei der die Gehäuseteile 4 und 5 entfernt wurden. Die Figur lässt erkennen, dass das Hybridkabel 2 elektrische Leiter 12 sowie Lichtwellenleiter 7 und 8 aufweist, die parallel verlaufen. Die elektrischen Leiter 12 führen auf elektrische Anschlüsse, die unterhalb des Druckblocks 13 an Kontakte herangeführt sind.

Fig. 3 zeigt den Steckverbinder mit entfernten elektrischen Leitern, so dass die Lichtwellenleiter 7 und 8 erkennbar sind, die im Bereich des Steckverbinders von Keramikhülsen 15, 16 umgeben sind. Das Hybridkabel lässt sich über den Klemmring 14 und die Verschraubung 3 fest am Steckverbinder 1 fixieren.

Die Formhülse 6 weist auf ihrer Oberseite neben den Durchbrüchen 9 an ihrem rückwärtigen Ende zwei Durchbrüche 42 und 43 auf, in die Federnasen eingreifen, die an dem durch die Formhülse 6 umgriffenen Verbindungsblock 11 angeordnet sind. Damit wird die Formhülse am Verbindungsblock verankert.

Fig. 4 zeigt den Verbindungsblock 11 mit aufgesetzter Platine 18. Die Platine 18 liegt an einer oberen Seitenwand des quaderförmigen Verbindungsblocks 11 an und weist ebenfalls Durchbrüche 21 und 22 auf, durch die die Rastnasen des Verbindungsblocks 11 hindurchgreifen. Der Verbindungsblock weist zwei Längsbohrungen zur Aufnahme der Lichtwellenleiterenden auf.

Fig. 5 zeigt die Platine 18 in freigestellter Darstellung. Die Platine kann ein- oder mehrlagig ausgebildet sein.

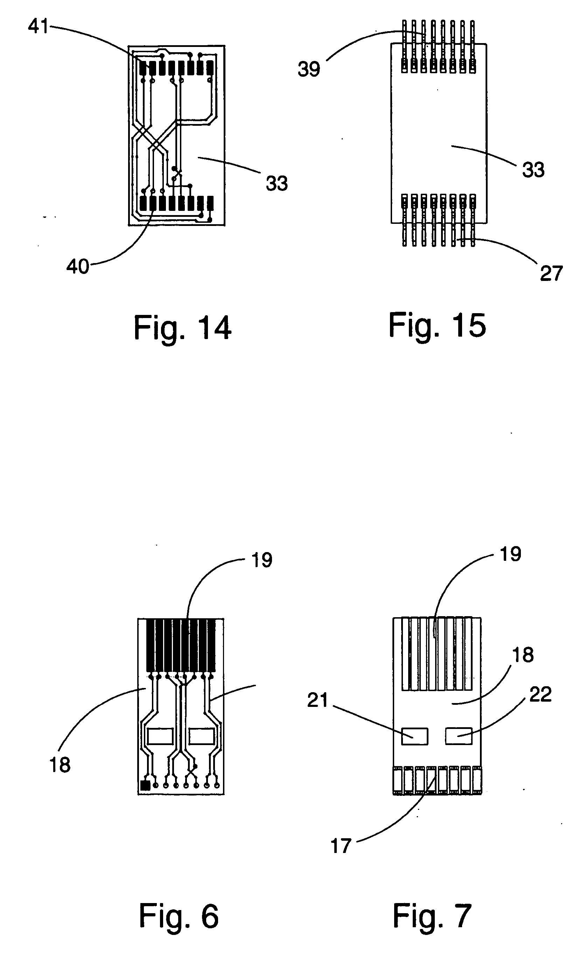

In Fig. 6 ist die Platine 18 in Aufsicht mit Leiterbahnen 20 und Kontaktflächen 19 dargestellt. Eine entsprechende Ansicht zeigt Fig. 7 mit angebrachten Schneidklemmen 17.

Die Montage eines Steckverbinders erfolgt in folgender Weise: das Hybridkabel mit freigelegten elektrischen und Lichtwellenleiterenden wird zunächst durch die Verschraubung 3 und dem Klemmring 14 hindurchgeführt. Dann werden die Lichtwellenleiterenden in die mit den Hülsen 15 und 16 versehenen Bohrungen des Verbindungsblocks 11 derart eingeführt, dass die Enden der Lichtwellenleiter ca. 1 cm aus dem Vorderende des Verbindungssteckers herausragen. Nun wird die Platine 18 auf die Oberseite des Verbindungsblocks 11 aufgesetzt. Die Platine kann mit dem Verbindungsblock 11 beispielsweise verrastet werden, sie kann jedoch auch zuvor an dem Verbindungsblock 11 angeklebt oder geschweißt worden sein.

Im folgenden Schritt werden die elektrischen Leiter 12 auf die Schneidklemmen 17 aufgelegt, die sich auf der Oberseite der Platine 18 befinden. Nicht benötigte Adernpaare können durch Brücken so kombiniert werden, dass eine Codierung entsteht, die von einer nachgeschalteten Intelligenz zur Identifikation erkannt werden kann. Eine solche Identifizierung kann auch durch einen Chip auf der Platine des Steckers realisiert werden, beispielsweise durch einen Codierungschip oder eine andere Art eines intelligenten Chips. Dieser kann mit einer nachgeschalteten Intelligenz kommunizieren.

Die Klemmung der elektrischen Leiter 12 mit den Schneidklemmen 17 erfolgt durch Aufbringen eines Druckblocks 13, der als quer über die Schneidklemmen 17 gelegter Kunststoffblock realisiert ist, der Ausnehmungen für die Schneidklemmen enthält. Bei Aufdrücken des Druckblocks 13 werden die elektrischen Leiter in den Schneidklemmen 17 fest verankert.

Im folgenden Schritt wird die Formhülse 6, welche sowohl die Durchbrüche 9 zur Kontaktierung der elektrischen Anschlüsse als auch vorderseitige Öffnungen zur Durchführung der Lichtwellenleiter enthält, auf den Verbindungsblock 11 aufgeschoben. Die Rastnasen des Verbindungsblocks 11 greifen durch die Öffnungen 21 und 22 der Platine 18 in die Öffnungen 42 und 43 der Formhülse 6 ein und verankern diese damit mit dem Verbindungsblock 11.

Schließlich werden die Gehäuseteile 4 und 5 um die gebildete Steckverbindereinheit herumgelegt. Die Gehäuseteile 4, 5 enthalten je ein rückwärtiges Teilgewinde, auf die in bekannter Weise die Verschraubung 3 aufgeschraubt werden kann, wobei durch den Klemmring 14 gleichzeitig eine Fixierung und Zugentlasung des Hybridkabels 2 am Steckverbinder erfolgt.

Die erfindungsgemäße Verwendung einer Platine im Steckverbinder führt zu einem kompakten Aufbau des Steckverbinders, bei dem die elektrische Kontaktierung im rückwärtigen Ende des Steckverbinders möglich ist, wobei das Vorderende in Form eines RJ45-Steckers sowohl die elektrischen Kontakte als auch ein Lichtwellenleiterpaar aufnehmen kann. Die Platine dient gleichzeitig dem Anschluss der elektrischen Leiter sowie der Ausbildung der Kontaktflächen zur Kontaktierung mit Federdrahtsätzen einer Buchse oder einer Kupplung.

Die Gehäuseelemente können aus Kunststoff ausgebildet sein oder auch aus Metall bzw. metallisiert sein, so dass eine hohe Störstrahlungsfestigkeit erreichbar ist.

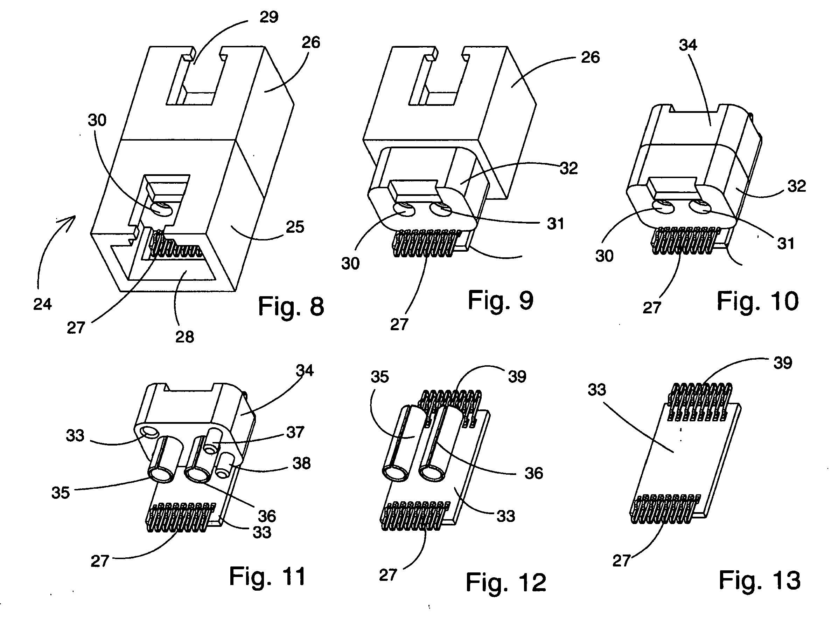

Fig. 8 zeigt eine Kupplung zur Verbindung zweier Kabel, welche mit Steckverbindern gemäß Fig. 1 versehen sind. Die Kupplung 24 weist zwei Gehäusehälften 25 und 26 auf, die mit Ausnehmungen 28 und 29 versehen sind, die einer üblichen RJ45-Buchsenform entsprechen.

Die Kupplung 24 enthält elektrische Federdrahtsätze 27 zur Kontaktierung elektrischer Anschlüsse eines anzuschließenden elektrischen Kabels.

Fig. 9 zeigt eine Steckkupplung, bei der eine Gehäusehälfte entfernt wurde. Es ist ein Halbblock 32 erkennbar, der zwei Führungen 30 und 31 enthält. Unterhalb des Halbblocks 32 befindet sich eine Platine 33, auf der ein Federdrahtsatz 27 angeordnet ist.

In Fig. 10 sind zwei gegeneinander gesetzte Halbblöcke 32 und 33 mit darunter angeordneter Platine 33 dargestellt.

Fig. 11 zeigt die Platine 33 mit nur einem Halbblock 34. Dieser enthält zwei Steckstifte 37 und 38, die in gegenüberliegende Bohrungen des nicht dargestellten Halbblocks 32 eingreifen und dadurch die Halbblöcke 32 und 34 miteinander fest verbinden. Der Halbblock 34 zeigt auch eine entsprechende Bohrung 23, in die ein Steckstift des Halbblocks 32 eingreifen kann.

Die Halbblöcke 32 und 34 weisen auch zwei fluchende Bohrungen auf, die Hülsen 35 und 36 aufnehmen, in die die Lichtleiterenden von anzuschließenden Steckverbindern gemäß Fig. 1 einsteckbar sind. Dadurch ist sichergestellt, dass die Lichtwellenleiter stirnseitig präzise aneinander stoßen. Die Hülsen können Kunststoff-, Metall- oder Keramikhülsen sein, die auch geschlitzt sein können, um die in Ferrulen gehaltene Glas- oder Kunststofffasem lagerichtig ausrichten zu können.

Fig. 12 zeigt die Hülsen 35 und 36 oberhalb der Platine 33 freigestellt. Diese ist in Fig. 13 gesondert dargestellt und zeigt zwei Federdrahtsätze 27 und 39 am jeweiligen Ende zum Anschluss an die Kontaktfläche 19 eines Steckverbinders gemäß Fig. 6.

Die Figuren 14 und 15 zeigen Aufsichten auf die Platine 33. Fig. 14 zeigt die Leiterbahnführung auf der Platine 33 zur Verbindung der Lötpunkte 40 und 41. Zur Ermöglichung einer gekreuzten Leitungsführung ist die Platine mehrlagig ausgeführt.

Fig. 15 zeigt die Platine 33 mit ausgebildeten Federdrahtsätzen 27 und 39.

Auch die Kupplung kann auf der Platine Codierungsmittel entsprechend denen der Steckverbinder enthalten.

Die Montage der Steckkupplung erfolgt dadurch, dass eine Platine gemäß Fig. 13 zusammen mit den beiden Halbblöcken 32 und 34, welche zuvor zusammengesteckt und mit Hülsen 35 und 36 versehen wurden, in die Gehäusehälften 26 und 25 eingesetzt werden. Die Gehäusehälften werden in geeigneter Weise miteinander verrastet oder verklebt. Da die Gehäusehälften jeweils in Form einer RJ45-Buchse ausgebildet sind, können sowohl übliche RJ45-Patchkabel als auch Steckverbinder gemäß Fig. 1 in der Steckbuchse miteinander verbunden werden.

Vorstehende Beschreibung zeigt spezielle Ausführungsformen der Erfindung, ohne dass diese darauf beschränkt ist. Die Verbindung der einzelnen Elemente der Steckverbindungen und Kupplungen kann auch auf andere Weise realisiert werden, z. B. durch Kleben, Verschweißen, Verschrauben oder entsprechende Verbindungselemente. Als zusammensetzbar angegebene Verbindungselemente, wie z. B. die Halbblöcke 32 und 34, können auch einstückig hergestellt werden. Nicht nur der Steckverbinder gemäß Fig. 1, sondern auch die Steckkupplung gemäß Fig. 8 kann Codierungselemente aufweisen, um eine Identifizierung der Steckkupplung zu erreichen. Auch die Steckkupplung kann metallisiert ausgebildet sein oder metallische Gehäusehälften aufweisen, um eine verbesserte Abschirmung zu erzielen.

Die anzuschließenden Kabel sind insbesondere als Hybridkabel ausgeführt. Das Prinzip der Erfindung ist jedoch auch bei getrennt verlaufenden elektrischen und Lichtwellenleiterkabeln verwendbar, die erst im Steckverbinder zusammengeführt sind.

### Bezugszeichen

- 1: Steckverbinder
- 2: Hybridkabel
- 3: Verschraubung
- 4: Gehäuseteil
- 5: Gehäuseteil
- 6: Formhülse
- 7: Lichtwellenleiter
- 8: Lichtwellenleiter
- 9: Durchbrüche
- 10: Verriegelungsvorrichtung
- 11: Verbindungsloch
- 12: elektrische Leiter
- 13: Druckblock
- 14: Klemmring
- 15: Hülse
- 16: Hülse
- 17: Schneidklemmen
- 18: Platine
- 19: Kontaktfläche
- 20: Leiterrahmen
- 21: Durchbruch
- 22: Durchbruch
- 23: Bohrung
- 24: Kupplung
- 25: Gehäusehälfte
- 26: Gehäusehälfte
- 27: Federdrahtsatz
- 28: Ausnehmung
- 29: Ausnehmung
- 30: Führung
- 31: Führung
- 32: Halbblock
- 33: Platine
- 34: Halbblock
- 35: Hülse
- 36: Hülse
- 37: Steckstift
- 38: Steckstift
- 39: Federdrahtsatz
- 40: Lötpunkte
- 41: Lötpunkte
- 42: Durchbruch
- 43: Durchbruch

## Patentansprüche

1. Steckverbinder in Form eines RJ-45 Anschlusssystems für ein Datenkabel (2), insbesondere Hybridkabel, mit wenigstens einem Lichtwellenleiter (7, 8) und dazu parallel geführten elektrischen Leitern (12), mit einer Halterung (11) für ein Ende der Lichtwellenleiter (7, 8) und mit elektrischen Kontakten (18) sowie einem Gehäuse (4, 5) zur Aufnahme der Halterung und der Kontakte,
**dadurch gekennzeichnet,**
**dass** das Gehäuse einen die Halterung bildenden quaderförmigen Verbindungsblock (11) enthält, der wenigstens zwei Durchlässe zur Führung von wenigstens zwei Lichtwellenleitern (7, 8) aufweist, dass eine Platine (18) mit Anschlusselementen (17) zum Anschluss der elektrischen Leiter (12) des Datenkabels vorgesehen ist, dass die Platine (18) mit einer Seite des Verbindungsblocks verbindbar ist, und dass die Platine parallel angeordnete Kontaktbahnen (19) enthält, die über Durchbrüche (9) einer den Verbindungsblock (11) und die Platine (18) umgebenden Formhülse (6) zur Kontaktierung von anzuschließenden elektrischen Verbindern zugänglich sind.

2. Steckverbinder nach Anspruch 1, **dadurch gekennzeichnet, dass** die Platine (18) Schneidklemmen (17) zum Anschließen der elektrischen Leiter (12) aufweist.

3. Steckverbinder nach Anspruch 2, **dadurch gekennzeichnet, dass** die parallel zueinander zu den Schneidklemmen (17) geführten elektrischen Leiter (12) mittels eines die Leiter quer überbrückenden mit parallelen Ausnehmungen versehenen Druckblocks (13) gemeinsam auf die Schneidklemmen (17) aufdrückbar sind.

4. Steckverbinder nach Anspruch 1, **dadurch gekennzeichnet, dass** die Formhülse (6) Ausnehmungen (40, 41) zur mechanischen Verrastung mit Federnasen des Verbindungsblocks (11) aufweist.

5. Steckverbinder nach Anspruch 1, **dadurch gekennzeichnet, dass** die Durchlässe des Verbindungsblocks mit Kunststoff-, Metall- oder Keramikhülsen (15, 16) zur Führung der Lichtleiterenden (7, 8) ausgestattet sind.

6. Steckverbinder nach einem oder mehreren der vorhergehenden Ansprüche, **dadurch gekennzeichnet, dass** das Gehäuse mehrteilig und mit einer Kabelklemmhülse (3) ausgebildet ist.

7. Steckverbinder nach Anspruch 1, **dadurch gekennzeichnet, dass** die Formhülse (6) mit einer Verriegelungsvorrichtung (10) zur Verbindung mit einer RJ-45 Buchse ausgebildet ist.

8. Steckverbinder nach Anspruch 1, **dadurch gekennzeichnet, dass** die Platine einstückig mit dem Verbindungsblock ausgebildet ist.

9. Steckkupplung in Form eines RJ-45 Anschlusssystems zur Aufnahme zweier Steckverbinder nach Anspruch 1 zur Verbindung zweier Datenkabel, insbesondere Hybridkabel, mit je wenigstens einem Lichtwellenleiter und dazu parallel geführten elektrischen Leitern, mit Halterungen für die Enden der Lichtwellenleiter und mit elektrischen Kontakten sowie einem Gehäuse, wobei ein quaderförmiger Führungsblock mit zwei fluchtenden Axialbohrungen (30, 31) zur Aufnahme und Ausrichtung der zu koppelnden Lichtwellenleiter vorgesehen ist,
**dadurch gekennzeichnet,**
**dass** der quaderförmige Führungsblock aus zwei stirnseitig gegeneinander gesetzten Halbblöcken (32, 34) gebildet ist, dass an der Außenseite des Führungsblocks eine Platine (33) mit zwei darauf endseitig angeordneten Federdrahtsätzen (27, 39) zur elektrischen Kopplung der zu verbindenden Steckverbinder vorgesehen ist, dass der Führungsblock und die Platine (33) miteinander ausgerichtet in einem zweiteiligen Kupplungsgehäuse (25, 26) aufgenommen sind und dass die Platine den Führungsblock in Steckrichtung beidseitig überragt.

10. Steckkupplung nach Anspruch 9, **dadurch gekennzeichnet, dass** der Führungsblock in seinen Axialbohrungen (30, 31) verankerte Kunststoff-, Metall- oder Keramikhülsen (35, 36) aufnimmt.

11. Steckkupplung nach Anspruch 9, **dadurch gekennzeichnet, dass** die Halbblöcke (32, 34) mittels in Sacklöchern des jeweils anderen Halbblocks eingreifende Stecknasen (37, 38) zueinander ausgerichtet sind.

12. Steckkupplung nach Anspruch 9, **dadurch gekennzeichnet, dass** die Federdrahtsätze (27, 39) auf die Platine aufgelötet sind.

13. Steckverbinder nach Anspruch 1, **dadurch gekennzeichnet, dass** die Platine eine Codierungsschaltung enthält, welche den Steckverbinder und/oder deren elektrische Leiter identifiziert, und dass die Codierungsschaltung über eine Auswerteschaltung abfragbar ist.

14. Steckkupplung nach Anspruch 9, **dadurch gekennzeichnet, dass** die Platine eine Codierungsschaltung enthält, welche den Steckverbinder und/oder deren elektrische Leiter identifiziert, und dass die Codierungsschaltung über eine Auswerteschaltung abfragbar ist.

## Claims

1. Plug connector in the form of an RJ 45 connection system for a data cable (2), in particular hybrid cable, with at least one optical waveguide (7, 8) and electrical conductors (12) led parallel thereto, with a holder (11) for one end of the optical waveguides (7, 8) and with electrical contacts (18) as well as a casing (4, 5) to accommodate the holder and the contacts,
**characterized in that**
the casing contains a rectangular parallelepiped connection block (11) forming the holder, which block has at least two passages for guiding at least two optical waveguides (7, 8), that a circuit board (18) with connection elements (17) is provided for connection of the electrical conductors (12) of the data cable, that the circuit board (18) is connectable to one side of the connection block, and that the circuit board contains contact paths (19) arranged in parallel, which are accessible via apertures (9) in a shaped sheath (6) enclosing the connection block (11) and the circuit board (18) for contacting of electrical connectors to be connected.

2. Plug connector according to claim 1, **characterized in that** the circuit board (18) has insulation-piercing connecting devices (17) for connecting the electrical conductors (12).

3. Plug connector according to claim 2, **characterized in that** the electrical conductors (12) led parallel to one another to the insulation-piercing connecting devices (17) can be pressed jointly onto the insulation-piercing connecting devices (17) by means of a pressure block (13) bridging the conductors transversely and provided with parallel recesses.

4. Plug connector according to claim 1, **characterized in that** the shaped sheath (6) has recesses (40, 41) for mechanical latching with spring lugs of the connection block (11).

5. Plug connector according to claim 1, **characterized in that** the passages of the connection block are fitted with plastic, metal or ceramic sheaths (15, 16) for guiding the ends of the optical waveguides (7, 8).

6. Plug connector according to one or more of the preceding claims, **characterized in that** the casing is formed in several parts and with a cable clamping sheath (3).

7. Plug connector according to claim 1, **characterized in that** the shaped sheath (6) is formed with a locking device (10) for connection to an RJ 45 socket.

8. Plug connector according to claim 1, **characterized in that** the circuit board is formed integrally with the connection block.

9. Plug-in coupling in the form of an RJ 45 connection system for receiving two plug connectors according to claim 1 for connecting two data cables, in particular hybrid cables, respectively with at least one optical waveguide and electrical conductors led parallel thereto, with holders for the ends of the optical waveguides and with electrical contacts as well as a casing, wherein a rectangular parallelepiped guide block with two aligned axial holes (30, 31) is provided for receiving and aligning the optical waveguides to be coupled,
**characterized in that**
the rectangular parallelpiped guide block is formed from two half-blocks (32, 34) set frontally opposite one another, that on the outside of the guide block a circuit board (33) is provided with two spring wire sets (27, 39) arranged on the end side thereof for the electrical coupling of the plug connectors to be connected, that the guide block and the circuit board (33) are accommodated aligned with one another in a two-part coupling casing (25, 26) and that the circuit board protrudes beyond the guide block in the plug-in direction on both sides.

10. Plug-in coupling according to claim 9, **characterized in that** the guide block takes up anchored plastic, metal or ceramic sheaths (35, 36) in its axial holes (30, 31).

11. Plug-in coupling according to claim 9, **characterized in that** the half-blocks (32, 34) are aligned to one another by means of plug-in lugs (37, 38) engaging in blind holes of the other half-block respectively.

12. Plug-in coupling according to claim 9, **characterized in that** the spring wire sets (27, 39) are soldered onto the circuit board.

13. Plug connector according to claim 1, **characterized in that** the circuit board contains a coding circuit, which identifies the plug connector and/or its electrical conductors, and that the coding circuit can be interrogated via an evaluation circuit.

14. Plug-in coupling according to claim 9, **characterized in that** the circuit board contains a coding circuit, which identifies the plug connector and/or its electrical conductors, and that the coding circuit can be interrogated via an evaluation circuit.

## Revendications

1. Connecteur en forme de système de connexion RJ-45 pour un câble de données (2), en particulier un câble hybride, comprenant au moins une fibre optique (7, 8) et des conducteurs électriques (12) parallèles à celle-ci, avec une attache (11) pour une extrémité des fibres optiques (7, 8) et avec des contacts électriques (18) ainsi qu'un boîtier (4, 5) pour recevoir l'attache et les contacts,
**caractérisé en ce que** le boîtier contient un bloc de raccordement parallélipipédique (11) qui forme l'attache et qui comporte au moins deux passages pour faire passer au moins deux fibres optiques (7, 8), **en ce qu'**il est prévu une platine (18) avec des éléments de connexion (17) pour connecter les conducteurs électriques (12) du câble de données, **en ce que** la platine (18) est apte à être reliée à un côté du bloc de raccordement, et **en ce que** la platine contient des pistes de contact parallèles (19) auxquelles on a accès grâce à des passages (9) d'une gaine profilée (6) qui entoure le bloc de raccordement (11) et la platine (18), pour la réalisation du contact d'éléments de raccordement électriques à connecter.

2. Connecteur selon la revendication 1, **caractérisé en ce que** la platine (18) comporte des pinces coupantes (17) pour la connexion des conducteurs électriques (12).

3. Connecteur selon la revendication 2, **caractérisé en ce que** les conducteurs électriques (12) parallèles qui mènent aux pinces coupantes (17) sont aptes à être pressés conjointement sur les pinces coupantes (17) grâce à un bloc de pression (13) qui couvre les conducteurs transversalement et qui est pourvu de creux parallèles.

4. Connecteur selon la revendication 1, **caractérisé en ce que** la gaine profilée (6) présente des creux (40, 41) pour l'enclenchement mécanique avec des saillies élastiques du bloc de raccordement (11).

5. Connecteur selon la revendication 1, **caractérisé en ce que** les passages du bloc de raccordement sont pourvus de douilles en matière plastique, en métal ou en céramique (15, 16) pour guider les extrémités de fibres optiques (7, 8).

6. Connecteur selon l'une au moins des revendications précédentes, **caractérisé en ce que** l'enveloppe est en plusieurs parties et comporte une douille serre-câble (3).

7. Connecteur selon la revendication 1, **caractérisé en ce que** la gaine profilée (6) comporte un dispositif de verrouillage (10) pour le raccordement à une douille RJ-45.

8. Connecteur selon la revendication 1, **caractérisé en ce que** la platine est formée d'une seule pièce avec le bloc de raccordement.

9. Raccord à fiches sous la forme d'un système de connexion RJ-45 destiné à recevoir deux connecteurs selon la revendication 1 pour raccorder deux câbles de données, en particulier des câbles hybrides, comportant chacun au moins une fibre optique et des conducteurs électriques parallèles à celle-ci, des attaches pour les extrémités des fibres optiques, des contacts électriques et une enveloppe, un bloc de guidage parallélipipédique avec deux perçages axiaux alignés (30, 31) étant prévu pour recevoir et orienter les fibres optiques à accoupler,
**caractérisé en ce que** le bloc de guidage parallélipipédique se compose de deux demi-blocs (32, 34) placés l'un contre l'autre au niveau de leur côté frontal, **en ce qu'**il est prévu sur le côté extérieur du bloc de guidage une platine (33) pourvue de deux jeux de fil d'acier à ressort (27, 39) qui sont disposés sur ladite platine (33) du côté des extrémités de celle-ci et qui sont destinés au couplage électrique des connecteurs à raccorder, **en ce que** le bloc de guidage et la platine (33) sont logés dans une enveloppe de raccord en deux parties (25, 26) en étant alignés, et **en ce que** la platine dépasse du bloc de guidage des deux côtés, dans le sens d'enfichage.

10. Raccord à fiches selon la revendication 9, **caractérisé en ce que** le bloc de guidage reçoit des douilles en matière plastique, en métal ou en céramique (35, 36) qui sont ancrées dans ses perçages axiaux (30, 31).

11. Raccord à fiches selon la revendication 9, **caractérisé en ce que** les demi-blocs (32, 34) sont alignés grâce à des saillies d'enfichage (37, 38) qui pénètrent dans des trous borgnes de l'autre demi-bloc.

12. Raccord à fiches selon la revendication 9, **caractérisé en ce que** les jeux de fil en acier à ressort (27, 39) sont brasés sur la platine.

13. Raccord à fiches selon la revendication 1, **caractérisé en ce que** la platine contient un circuit de codage qui identifie le connecteur et/ou les conducteurs électriques de celui-ci, et **en ce que** le circuit de codage est apte à être interrogé par l'intermédiaire d'un circuit d'analyse.

14. Raccord à fiches selon la revendication 9, **caractérisé en ce que** la platine contient un circuit de codage qui identifie le connecteur et/ou les conducteurs électriques de celui-ci, et **en ce que** le circuit de codage est apte à être interrogé par l'intermédiaire d'un circuit d'analyse.
